# EUROPEAN PATENT APPLICATION

(11) **EP 1 139 402 A1**
(43) Date of publication of application: **04.10.2001**
(21) Application number: 00106566.3
(22) Date of filing: 27.03.2000
(51) Int. Cl.: H01L 21/311, H01L 21/768, H01L 21/762, H01L 21/66, C23C 16/44, C23C 16/40

(54) **Method and arrangement for depositing a dielectric layer**

(71) Applicant: Infineon Technologies AG, 81669 München (DE); Semiconductor 300 GmbH & Co. KG, 01074 Dresden (DE); MOTOROLA, INC., Schaumburg, IL 60196 (US)
(72) Inventor: John, Peggy, 01139 Dresden (DE); Vatel, Oliver, 01309 Dresden (DE); Shahvandi, Iraj, 01326 Dresden (DE)
(74) Representative: Fischer, Volker, Dipl.-Ing.

(57) **Abstract**

The present invention relates to a method and an arrangement for depositing a dielectric layer (3) with a High Density Plasma process which also planarises the surface (8) of the substrate (2). Therefore the deposition of the dielectric layer (3) is divided into three time periods where during the first time period the gap is filled with a low etch to deposition rate, during the second time period a planarisation takes place while using a high etch to deposition rate and during the third time period the thickness of the dielectric layer (3) is increased while using a low etch to deposition rate.

## Description

The present invention relates to a method and arrangement for depositing a dielectric layer with a High Density Plasma deposition process which planarises the surface of a substrate.

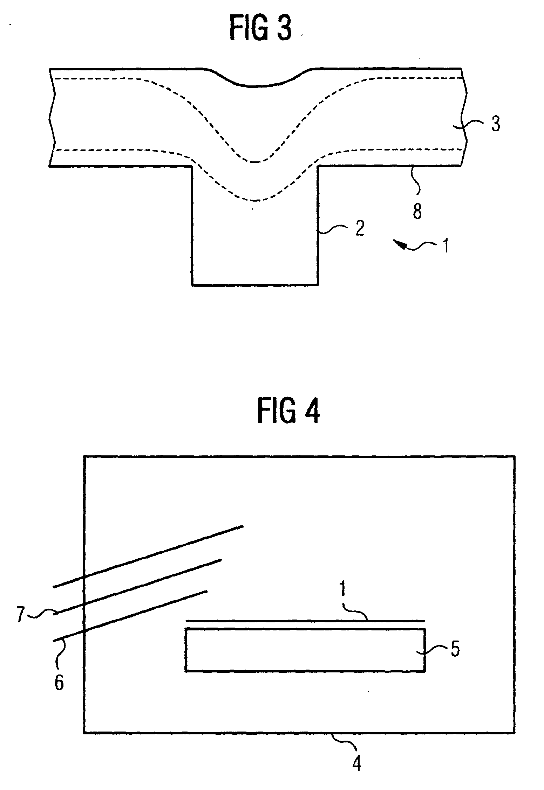

From "Technologie Hochintegrierter Schaltungen, 2. Auflage, D. Widmann" pages 19 to 21 and figures 3.1.7a, b on page 22 it is known that a gap can be filled with a deposition/etch process by varying the deposition/etch rate of a High Density Plasma deposition process.

In the patent US 6,001,267 a High Density Plasma chemical processing (HDP) reactor, with multiple etching gas injectors is disclosed.

When a dielectric layer is deposited on a wafer substrate to fill a gap, usually a CMP (Chemical Mechanical Polishing) step is needed to planarise the surface of the substrate after the deposition of the dielectric layer.

It is the object of the present invention to provide a method and an arrangement for depositing a dielectric layer with a High Density Plasma deposition process which planarises the surface of the substrate.

To attain the above mentioned object, a method for depositing a dielectric layer with a High Density Plasma deposition process is provided comprising the steps:
Depositing a dielectric layer on a surface of a substrate comprising the filling of a gap which is arranged in the substrate;
Changing the etch to deposition rate of a High Density Plasma deposition process to a higher etch to deposition rate, so that the deposited dielectric layer is planarised;
Changing the etch to deposition rate of the High Density Plasma deposition process to a lower etched deposition rate, so that the thickness of the dielectric layer is increased.

This method describes an integrated process in a High Density Plasma deposition chamber (HDP) which is capable of filling a gap and planarising a surface without interrupting the process, just by adjusting the etch to deposition rate in the HDP process to adequate values. The pressure in the deposition chamber during a HDP process is usually between 1 and 0,1 Pa.

Usually a standard HDP process is a combination of a deposition and etching process and uses a low etch to deposition ratio in order to provide a good gap-filling capability. After the gap-fill a CMP process is needed to planarise the surface of the substrate. The planarisation with the CMP can inventively be saved, so that the process cost can be reduced.

Also a lower number of process tools is needed, so that the overall throughput can be increased. By depositing the dielectric layer in an integrated process in the HDP chamber, substrate handling is decreased, which reduces the defectivity of the substrate. The inventive method makes the HDP process work in different etch to deposition regimes, compared to a standard gap-fill process.

An embodiment of the invention comprises an integrated metrology system which measures the thickness and uniformity of the deposited dielectric layer during deposition and the measured data is used to control the deposition. The in situ metrology enables the regulation of the different etch to deposition rate processes in order to achieve good gap-fill and good planarisation of the surface.

A further embodiment of the invention comprises multiple etching gas injectors which are used to inject the etching gas into the High Density Plasma process chamber. The etching gas injectors have different lengths and different gas lines to enable processes with uniform and non-uniform etch patterns.

Another embodiment of the invention is that the thickness and uniformity measurement data is used to adjust the etching gas flows in the different etching injectors. The individual control of the gas injectors enables good control of the etch process uniformity. The data measured by the metrology system can be used to determine the thickness and the uniformity of the deposited dielectric layer. Further, it can be used to adjust the etching gas flows through the different injectors.

With respect to the arrangement, the object of the present invention is solved by an arrangement for planarising the surface of a substrate comprising a High Density Plasma process chamber with multiple etching gas injectors in the chamber to provide etching uniformity on large wafers. The multiple etching gas injectors provide a more uniform etching process which is important for large wafers.

In a preferred embodiment of the invention the multiple gas injectors can be controlled individually. The individual controllability of the injectors enables a process with higher uniformity and an optimisation process to improve uniformity.

Further embodiments of the invention are given in the dependent claims.

The invention is further described using examples with reference to figures.

The figures show:
- Figure 1: substrate after deposition of dielectric layer with low etch to deposition rate;
- Figure 2: substrate with dielectric layer after a step with high etch to deposition rate;
- Figure 3: substrate with dielectric layer after a deposition step to increase the dielectric layer thickness.
- Figure 4: High Density Plasma chamber.

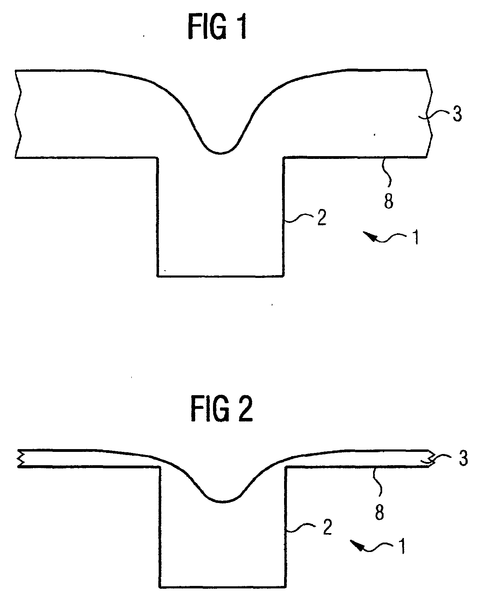

Figure 1 shows a substrate 1 with a gap 2 and a deposited dielectric layer 3 which fills the gap 2 and is also arranged on the surface 8 of the substrate 1. The process to build the arrangement in figure 1 provides a substrate with a gap 2 and deposits a dielectric layer in a High Density Plasma deposition chamber while using a low etch to deposition rate to provide the process with a good gap-fill capability.

According to figure 2 the process parameters during the HDP process have been changed to a high etch to deposition rate so that the thickness of the dielectric layer on top of the surface 8 of the substrate 1 has been decreased.

With respect to figure 3, the process parameters of the High Density Plasma deposition process are changed to a low etch to deposition rate so that the thickness of the dielectric layer 3 is increased. This provides a good planarisation of the dielectric layer 3.

In figure 4 a High Density Plasma chamber 4 containing a chuck 5 is shown. A substrate 1 is arranged on top of the chuck 5. An injector 6 is arranged to introduce process gas into the process chamber. To provide better homogeneity for the etch and the deposition processes, a second injector 7 is arranged to inject process gas into the chamber. The injector 6 and the second injector 7 can be controlled individually to provide a full process control with high uniformity.

## Claims

1. Method for depositing a dielectric layer with a High Density Plasma process comprising the steps:
- depositing a dielectric layer (3) on a surface (8) of a substrate (1) comprising the filling of a gap (2) which is arranged in the substrate (1);
- changing the etch to deposition rate of the High Density Plasma process to a higher etch to deposition rate, so that the deposited dielectric layer (3) is planarised;
- changing the etch to deposition rate of the High Density Plasma process to lower etch to deposition rates, so that the thickness of the dielectric layer (3) is increased.

2. Method according to claim 1,
**characterised in that**
an integrated metrology system measures the thickness and uniformity of the deposited dielectric layer (3) during the deposition and the measured data is used to control the deposition.

3. Method according to claim 1 or 2,
**characterised in that**
multiple etching gas injectors (6, 7) are used to inject etching gas into the High Density Plasma process chamber.

4. Method according to claim 3,
**characterised in that**
the thickness and uniformity measurement data is used to adjust the etching gas flows in the different etching gas injectors (6, 7).

5. Arrangement for planarising the surface of a substrate comprising a High Density Plasma process chamber,
**characterised in that**
there are multiple etching gas injectors (6, 7) in the chamber (4) to provide etching uniformity for large wafers.

6. Arrangement according to claim 5,
**characterised in that**
the multiple gas injectors (6, 7) can be controlled individually.
